Europäisches Patentamt

European Patent Office

Office européen des brevets

(19)

(11) Veröffentlichungsnummer: **0 230 517**
**B1**

(12) **EUROPÄISCHE PATENTSCHRIFT**

(45) Veröffentlichungstag der Patentschrift:
06.06.90

(51) Int. Cl.⁵: **F16P 3/14**

(21) Anmeldenummer: 86113581.2

(22) Anmeldetag: 02.10.86

(54) Lichtschranke.

(30) Priorität: 20.01.86 DE 3601516

(43) Veröffentlichungstag der Anmeldung:
05.08.87 Patentblatt 87/32

(45) Bekanntmachung des Hinweises auf die Patenterteilung:
06.06.90 Patentblatt 90/23

(84) Benannte Vertragsstaaten:
CH DE FR GB IT LI LU SE

(56) Entgegenhaltungen:
WO-A-81/00750
DE-A- 2 223 032
GB-A- 1 603 197
US-A- 3 970 846

(73) Patentinhaber: AG für industrielle Elektronik AGIE
Losone bei Locarno, CH-6616 Losone/Locarno(CH)

(72) Erfinder: Salim, Ehsan, Via Pezzavenerdi, 42,
CH-6616 Losone(CH)

(74) Vertreter: EGLI-EUROPEAN PATENT ATTORNEYS,
Widenmayerstrasse 5, D-8000 München 22(DE)

ACTORUM AG

## Beschreibung

Die vorliegende Erfindung betrifft eine Lichtschranke nach dem Oberbegriff des Patentanspruchs 1. Eine solche Lichtschranke in aus der US-A 3 970 846 bekannt.

Bei dieser Lichtschranke besteht der dritte Kanal aus einer Rückkopplungsschleife, die auf dynamische Signalanteile anspricht. Die Rückkopplungsschleife dient lediglich dazu, den Einfluß von einfallendem Umgebungslicht sowie den Einfluß der Umgebungstemperatur auf das Verhalten der Fototransistoren zu kompensieren und gegebenenfalls eine ungleichmäßige Anpassung der Charakteristika der einzelnen Fototransistoren auszugleichen, indem die Eingangsspannungen der Fototransistoren in geeigneter Weise rückgekoppelt gesteuert werden. Ein möglicher Ausfall von Bauteilen innerhalb der verschiedenen Kanäle kann bei dieser bekannten Lichtschranke unerkannt bleiben.

Gegenüber diesem Stand der Technik liegt der vorliegenden Erfindung die Aufgabe zugrunde, eine Lichtschranke der eingangs genannten Art so weiterzubilden, daß die Betriebssicherheit weiter erhöht wird.

Diese Aufgabe wird bei einer Lichtschranke gemäß dem Oberbegriff des Patentanspruchs 1 durch die im kennzeichnenden Teil des Patentanspruchs 1 angegebenen Merkmale gelöst.

Bevorzugte Weiterbildungen der erfindungsgemäßen Lichtschranke sind Gegenstand der Unteransprüche.

Nachfolgend werden Ausführungsbeispiele der erfindungsgemäßen Lichtschranke unter Bezugnahme auf die beiliegenden Zeichnungen näher erläutert. Es zeigen:

Fig. 1 ein Blockschaltbild der Lichtschranke einschließlich der Auswerteschaltung nach der Erfindung;
Fig. 2 ein Impulsdiagramm ausgewählter Impulse der Fig. 1;
Fig. 3 ein Blockschaltbild einer Variante des senderseitigen Multiplexers samt dessen Ansteuerung;
Fig. 4 ein Impulsdiagramm zur Erläuterung der Fig. 3;
Fig. 5 ein Blockschaltbild der Rücksetzschaltung der Fig. 1;
Fig. 6 ein Impulsdiagramm zur Erläuterung der zeitlichen Aufeinanderfolge des Schaltens der Relais der Rücksetzschaltung; und
Fig. 7 ein detailierteres ausschnittweises Schaltbild von Teilen der Auswerteschaltung und der Rücksetzschaltung nach einem weiteren Ausführungsbeispiel der Erfindung.

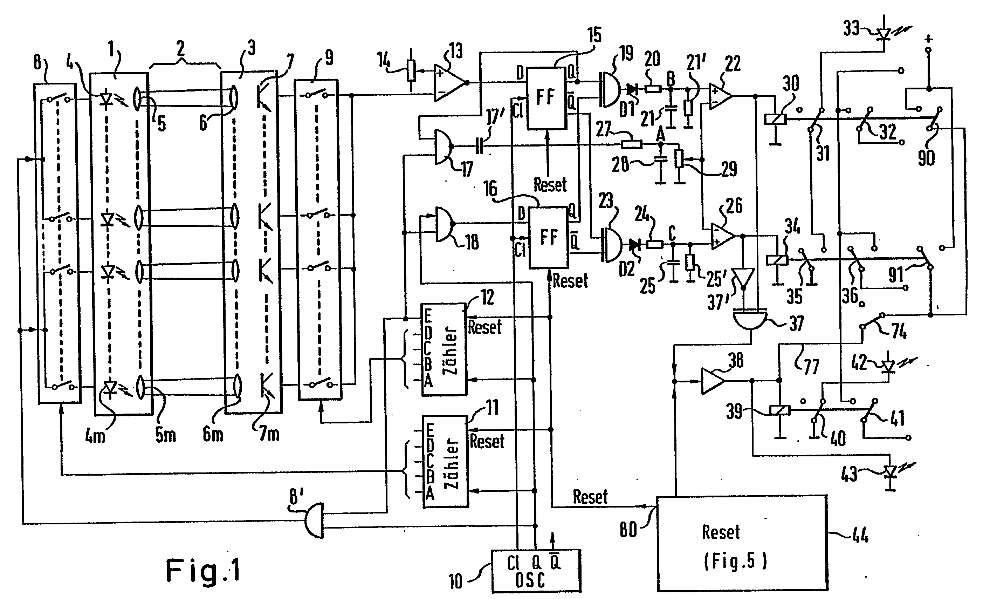

Fig. 1 zeigt ein Blockschaltbild der Schaltungsanordnung nach der Erfindung. Ein Sender 1 sendet Lichtstrahlen, die beispielsweise im Infrarotbereich liegen, über eine zu überwachende Strecke 2 an einen Empfänger 3. Der Sender 1 enthält hier eine Reihe von Leuchtdioden 4 bis 4m, die normalerweise in Form einer geradlinigen "Diodenzeile" angeordnet sind. Jeder Leuchtdiode 4 ist hier eine Optik in Form einer Linse 5 bis 5m zugeordnet, welche die Lichtstrahlen schärfer bündelt. Der Empfänger 3 besitzt eingangsseitig ebenfalls eine Optik in Form von Linsen 6 bis 6m, welche die empfangenen Lichtstrahlen auf photoempfindliche Elemente 7 bis 7m leiten. Jeder der Leuchtdioden 4 bis 4m ist ein bestimmtes photoempfindliches Element 7 bis 7m zugeordnet. Durch die Optik 5, 6 wird auch dafür gesorgt, daß Lichtstrahlen einer Leuchtdiode im wesentlichen nur auf das ihr zugeordnete photoempfindliche Element geleitet werden.

Die einzelnen Leuchtdioden 4 werden sequentiell nacheinander aktiviert, was durch einen sendeseitigen Multiplexer 8 erfolgt. In gleicher Weise werden die empfängerseitigen photoempfindlichen Elemente 7 sequentiell nacheinander über einen empfängerseitigen Multiplexer 9 abgefragt. Die beiden Multiplexer 8 und 9 sind miteinander synchronisiert, so daß (in einer Meßphase) immer nur dasjenige photoempfindliche Element 7 abgefragt wird, dessen zugeordnete Leuchtdiode 4 sendet.

Ein Oszillator 10 erzeugt Rechteckimpulse mit einer fest vorgegebenen Frequenz, wobei an seinem Ausgang Cl Taktimpulse und an seinem Ausgang Q Steuerimpulse ausgegeben werden, die in ihrer Frequenz im Verhältnis 1:2 gegenüber den Taktimpulsen untersetzt sind. Die Impulse des Ausganges Q des Oszillators 10 werden zwei Zählern 11 und 12 zugeführt, die hier Binärzähler sind. Diese Zähler laufen ebenfalls synchron zueinander und dienen zur Ansteuerung der Multiplexer 8 und 9. Je nach Zählerstand der Zähler 11 und 12 sind die Multiplexer 8 und 9 in unterschiedlichen, jedoch eindeutig definierten Schaltzuständen. Weiterhin werden die Ausgangsimpulse am Ausgang Q des Oszillators 10 dem Signaleingang des Multiplexers 8 zugeführt. In die Zuleitung ist ein UND-Gatter 8' geschaltet, dessen anderer Eingang mit der höchsten Bitstelle (E) des Zählers 12 verbunden sind. Nur wenn diese Bitstelle eine "1" führt, wird also der Sender aktiviert. Diese Bitstelle steuert zwischen einer Meßphase und einer Testphase um. Während der Testphase sind die Sender inaktiv und es werden nur die Empfänger abgefragt. Je nach Zählstand des Zählers 11 wird dann ein Impuls vom Multiplexer 8 an eine der Leuchtdioden 4 weitergeleitet, welche für die Dauer dieses Impulses Licht aussendet. Dieses Licht wird von dem zugeordneten photoempfindlichen Element 7 empfangen, wobei über den Multiplexer 9 und dessen Ansteuerung durch den Zähler 12 genau das zugeordnete photoempfindliche Element 7 abgefragt wird, so daß sein Ausgangssignal am Ausgang des Multiplexers 9 erscheint. (Bei dieser Betriebsweise wirkt der Multiplexer 9 genauer gesagt als Demultiplexer).

Am Rande sei noch erwähnt, daß statt der beiden Zähler 11 und 12 auch nur ein Binärzähler verwendet werden kann, der dann parallel die beiden Multiplexer 8 und 9 ansteuert. Aus Gründen der Ausfallsicherheit der einzelnen Bauelemente werden hier jedoch zwei separate Zähler bevorzugt.

Das Ausgangssignal des Multiplexers 9 wird einer Auswerteschaltung zugeleitet, die im Prinzip mit drei Kanälen arbeitet. Der eine Kanal überwacht grundsätzlich das Auftreten eines Lichtimpulses. Der zweite Kanal überwacht grundsätzlich die Pausen zwischen zwei Lichtimpulsen während der dritte Kanal die beiden anderen Kanäle überwacht. Im einzelnen ist die Auswerteschaltung wie folgt aufgebaut:

Das Ausgangssignal des Multiplexers 9 wird dem invertierenden Eingang eines Komparators 13 zugeführt, dessen positivem Eingang ein Vergleichswert von einem Vergleichswertgeber 14 zugeführt wird. Der Komparator 13 wirkt dabei als invertierenden Komparator. Sein Ausgangssignal wird dem D-Eingang eines D-Flipflops 15 zugeführt. Der Takteingang CI dieses Flipflops 15 ist an den Ausgang CI des Oszillators 10 angeschlossen. Der Ausgang Q des Flipflops 15 ist mit einem Eingang eines Exclusiv-Oder-Gatters (im folgenden EX-OR-Gatter) verbunden. (Das D-Flipflop arbeitet in der Weise, daß es bei Eintreffen eines Taktimpulses am Eingang CI dann seinen Schaltzustand so ändert, daß sein Ausgang Q auf den logischen Pegel seines D-Einganges gebracht wird.)

Ein zweites D-Flipflop 16 ist mit seinem Takteingang CI ebenfalls an den Ausgang CI des Oszillators 10 angeschlossen. Sein D-Eingang ist an den Ausgang eines NAND-Gatters 18 angeschlossen, dessen einer Eingang an den Ausgang Q des Oszillators 10 angeschlossen ist und dessen anderer Eingang an den Zähler 12 angeschlossen ist und zwar an den Ausgang E, welcher die höchste Bitstelle des Zählers 12 führt. Die Zähler 11 und 12 haben n-Ausgänge und können somit bis $2^n$ zählen. Die Anzahl m der Leuchtdioden 4 und der photoempfindlichen Elemente 7 ist daher $m = 2^{n-1}$. Bei einem vollen Zählzyklus der Zähler 11 und 12 schalten also die Multiplexer 8 und 9 zweimal alle ihre möglichen Schaltzustände durch.

Der Ausgang Q des zweiten Flipflops 16 ist mit dem anderen Eingang des EX-OR-Gatters 19 verbunden. In analoger Weise sind die beiden negierten Ausgänge $\overline{Q}$ der Flipflops 15 und 16 mit den beiden Eingängen eines weiteren EX-OR-Gatters 23 verbunden. Die Ausgänge beider EX-OR-Gatter 19 und 23 sind über in Durchlassrichtung geschaltete Dioden D1 und D2 mit integrierenden RC-Gliedern 20, 21 bzw. 24, 25 verbunden, wobei deren Ausgang (Punkte B bzw. C) jeweils mit dem nicht-invertierenden Eingang eines Komparators 22 bzw. 26 verbunden sind. Der Komparator 26 des zweiten Kanals ist zusätzlich ein invertierender Komparator. Parallel zu den Kondensatoren 21 und 25 liegen Widerstände 21' und 25', die die Entladezeitkonstante der Kondensatoren 21 und 25 bestimmen. Die Dioden D1 und D2 verhindern, daß sich die Kondensatoren 21 und 25 über die Ausgänge der EX-OR-Gatter 19 und 23 entladen können.

Der erste Kanal wird durch die Bauteile 15, 19, D1, 20, 21, 21' und 22 gebildet. Der zweite Kanal wird durch die Bauteile 16, 23, D2, 24, 25, 25' und 26 gebildet.

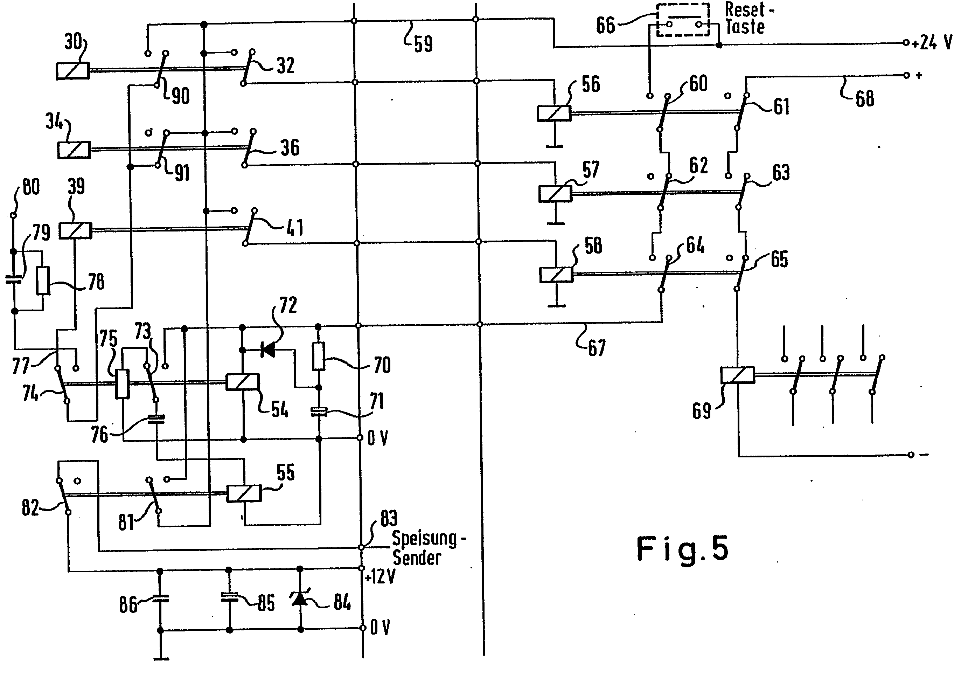

Der dritte Kanal enthält ein NAND-Gatter 17, dessen einer Eingang mit Ausgang Q des Flipflops 15 und dessen anderer Eingang mit dem Ausgang E des Zählers 12 verbunden ist. Der Ausgang des NAND-Gatters 17 führt über einen Koppelkondensator 17', der nur dynamische Anteile des Ausgangssignales des NAND-Gatters 17 durchlässt, zu einem dritten integrierende RC-Glied 27, 28, dessen Ausgang A über einen Spannungsteiler (Widerstand) 29 an die beiden invertierenden Eingänge der Komparatoren 22 und 26 angeschlossen ist. Die Komparatoren 22 und 26 steuern je ein Relais 30 bzw. 34 an, wobei beide Relais hier je drei Schaltkontakte 31, 32 und 90 bzw. 35, 36 und 91 betätigen. Die beiden Schaltkontakte 31 und 35 sind in Reihe zueinander geschaltet, wobei diese Reihenschaltung auf der einen Seite mit Masse verbunden ist und auf der anderen Seite mit einer Leuchtdiode 33, welche mit ihrem anderen Anschluß an einer nicht dargestellten Spannungsversorgung liegt. Die Schaltkontakte 32, 36, 90 und 91 sind Kontakte für die Steuerung einer von der Lichtschranke überwachten Anlage, Maschine etc. (Ausgänge der Schaltung) sowie für eine Rücksetzschaltung, die im Zusammenhang mit Fig. 5 erläutert wird. Alle Schaltkontakte sind in Fig. 1 im Ruhezustand dargestellt, d. h. bei nicht- erregtem Relais.

Zusätzlich sind die beiden Ausgänge der Komparatoren 22 und 26 mit je einem Eingang eines EX-OR-Gatters 37 verbunden, dessen Ausgang über einen Verstärker 38 ein weiteres Relais 39 ansteuert, das zwei Schaltkontakte 40 und 41 besitzt. Der Ausgang des Komparators 26 wird dabei einem invertierenden Eingang des EX-OR-Gatters zugeführt, was durch einen Inverter 37' angedeutet ist. Umgekehrt kann auch - sofern vorhanden - der nicht-invertierte Ausgang des Komparators 26 mit einem nicht-invertierenden Eingang des EX-OR-Gatters 37 verbunden sein.

In Reihe zu dem Schaltkontakt 40 liegt eine weitere Leuchtdiode 42. Der Schaltkontakt 41 dient ebenfalls als Ausgang der Schaltung und wird ebenfalls für die erwähnte Rücksetzfunktion verwendet. An den Ausgang des Verstärkers 38 ist noch eine weitere Leuchtdiode 43 angeschlossen. Schließlich ist der Ausgang des EX-OR-Gatters 37 an eine Rücksetzschaltung 44 angeschlossen, die im Zusammenhang mit Fig. 5 ausführlicher erläutert wird. Diese Rücksetzschaltung (Reset) ist mit ihrem Ausgangsanschluß 80 an die Rücksetzeingänge der Zähler 11 und 12 sowie der Flipflops 15 und 16 angeschlossen.

Sobald dort ein Rücksetzbefehl (logischer Pegel "0") erscheint, werden die beiden Flipflops 15 und 16 sowie die beiden Zähler 11 und 12 in einen definierten Zustand zurückgesetzt, womit die beiden Zähler und die beiden Flipflops synchronisiert werden. Die Schaltkontakte 90 und 91 legen Betriebsspannung auf eine Leitung 77, wenn das Relais 30 erregt und/oder das Relais 34 nicht erregt sind. Die Leitung 77 ist mit dem Relais 39 verbunden. Es kann daher entweder durch den Verstärker 38 oder die Schaltkontakte 90 bzw. 91 erregt werden. In die Leitung 77 ist noch ein weiterer Schaltkontakt 74 zwischengeschaltet, der bei störungsfreiem Betrieb in der in Fig. 1 gezeigten geschlossenen Stellung ist. Er wird durch ein Relais 54 (Fig. 5) der Rücksetzschaltung betätigt.

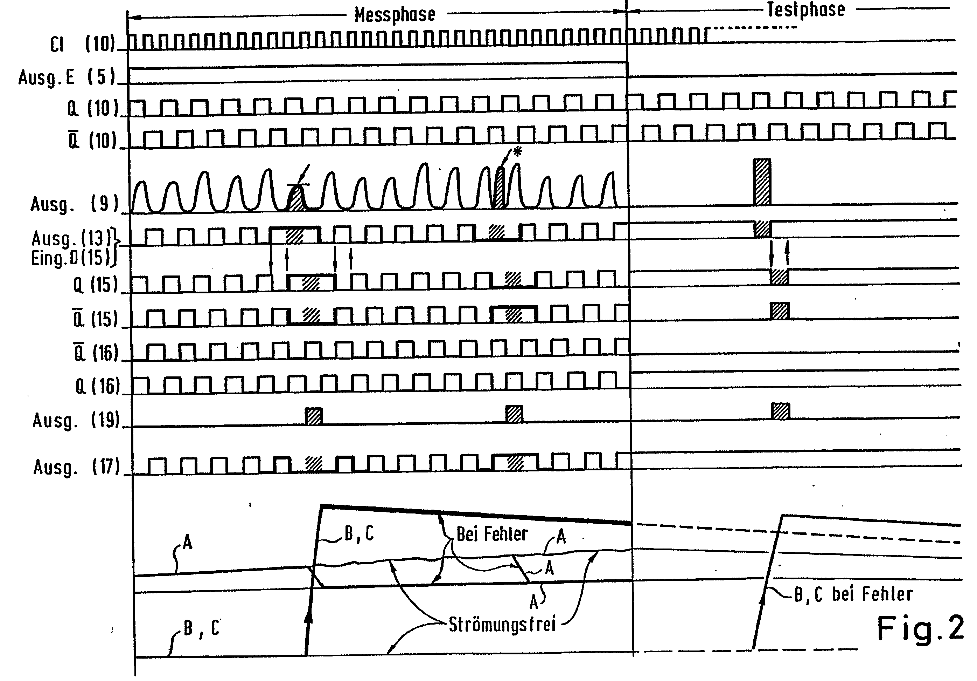

Im folgenden wird die Wirkungsweise der Schaltungsanordnung der Fig. 1 im Zusammenhang mit dem Impulsdiagramm der Fig. 2 erläutert. Fig. 2 zeigt dabei den zeitlichen Verlauf ausgewählter Signale, wobei sich die in Fig. 2 angegebenen Bezugszeichen auf die Bauelemente der Fig. 1 beziehen. Mit "Q (15)" ist also beispielsweise die Impulsfolge am Ausgang Q des Flipflops 15 bezeichnet.

Der Oszillator 10 erzeugt kontinuierlich die Taktimpulse CI (10). In einer "Meßphase" sei der Ausgang E des Zählers 12 auf logisch "1", wobei diese Meßphase im dargestellten Ausführungsbeispiel die Dauer von 16 Impulsen des Ausganges Q des Oszillators 10 hat.

Es sei nun angenommen, daß die Zähler 11 und 12 den Zählerstand "1...000" haben (E ist auf"1"; alle anderen Zählerausgänge auf "0"). Der erste Impuls Q (10) bringt die beiden Zähler 11 und 12 in den Zählzustand "100...01"" worauf die beiden Multiplexer 8 und 9 nun das erste Paar von zugeordneten Leuchtdioden und photoempfindlichen Elementen aktivieren. Weiterhin versorgt der erste Impuls Q (10) über den entsprechend durchgeschalteten Multiplexer 8 die erste Leuchtdiode 4 mit Energie, wobei der Lichtstrahl bei nicht unterbrochener Strecke 2 auf das erste photoempfindliche Element 7 auftrifft. Dieses gibt dann einen Spannungsimpuls ab, der über den Multiplexer 9 zu dem Komparator 13 gelangt. Die entsprechende Signalfolge ist in Fig. 2 mit "Ausg. (9)" bezeichnet. Der Komparator 13 vergleicht diese Impulsfolge mit einem voreingestellten Schwellwert (vom Bezugswertgeber 14). Ist die Amplitude der Signale am Ausgang des Multiplexers 9 größer als dieser Schwellwert, so schaltet der Komparator 13 durch. Ist sie dagegen kleiner als der Schwellwert, schaltet der Komparator 13 nicht durch. Aufgrund der zusätzlichen invertierenden Wirkung des Komparators 13 erscheinen an seinem Ausgang also die Signale "Ausg. (13)" der Fig. 2. Der Komparator 13 wirkt damit als invertierender Impulsformer. Sobald am Eingang D des Flipflops 15 eine logische "1" erscheint, schaltet es beim nächst folgenden Taktimpuls CI um, so daß sich die Signalfolgen Q (15) und $\bar{Q}$ (15) ergeben. Diese Signale sind um eine Phase von 180° des Signales Q (10) gegenüber den Signalen am Ausgang des Komparators 13 verschoben, was durch die Eigenschaften des D-Flipflops bedingt ist. Das Signal Q (15) stellt somit kurz zusammengefaßt ein phasenverschobenes, invertiertes und zu Rechteckimpulsen geformtes Signal des IST-Zustandes am Ausgang des Multiplexers 9 dar. Jeder Impuls repräsentiert dabei eine der $2^{n-1}$ Paare von Leuchtdioden und photoempfindlichen Elementen, da bei jedem weiteren Impuls Q (10) ja die Zähler 11 und 12 weiterschalten und dementsprechend die Multiplexer 8 und 9 das nächste Paar 4 und 7 aktivieren.

Das Flipflop 16 erhält an seinem D-Eingang während der Meßphase die Impulse $\bar{Q}$ (10), die phasenverschoben somit den Sollwert für die Lichtimpulse darstellen (E von 12 ist auf "1"). Auch hier ist durch die Wirkung des Flipflops 16 eine entsprechende Verzögerung bzw. Phasenverschiebung vorhanden. In dem EX-OR-Gatter 19 werden nun die Signale der Q-Ausgänge der Flipflops 15 (IST-Wert) und 16 (SOLL-Wert) miteinander "verglichen". Sind diese beiden Signale gleich (beide "0" oder beide "1"), so führt der Ausgang des EX-OR-Gatters 19 eine "0". Sind sie dagegen verschieden, so führt der Ausgang des EX-OR-Gatters eine "1". Letzteres ist ein Zeichen für das Vorhandensein eines Fehlers. Ein solcher Fehler während der Meßphase ist in Fig. .2 anhand der schraffiert dargestellten Impulse erläutert.

Es sei angenommen, daß die Lichtstrecke 2 an einer Stelle unterbrochen sei, so daß der Signalpegel am Ausgang des Multiplexers 9 den Schwellwert nicht erreicht. Dementsprechend bleibt der Ausgang des invertierenden Komparators 13 auf einer "1" und geht nicht auf "0", wie es bei fehlerfreiem Betrieb der Fall sein müßte. Entsprechend bleibt (phasenverschoben) auch der Ausgang Q (1$\underline{5}$) auf einer "1" während der invertierte Ausgang $\bar{Q}$ (15) auf einer "0" bleibt. Damit liegen am EX-OR-Gatter 19 eine "1" (von Q (15)) und eine "0" (von Q (16)), so daß das EX-OR-Gatter den in Fig. 2 dargestellten (schraffiert) "Fehlerimpuls" abgibt. Entsprechend sind auch die invertierten Ausgänge $\bar{Q}$ der Flipflops 15 und 16 dann verschieden ($\bar{Q}$ 15 ist auf "0"; $\bar{Q}$ 16 ist auf "1"), so daß auch das EX-OR-Gatter 23 einen entsprechenden Impuls abgibt. Diese Impulse werden nun in den RC-Gliedern 20, 21 bzw. 24, 25 aufintergriert, so daß an den Punkten B und C das in Fig. 2 ganz unten dargestellte Signal (B und C) erscheint. Mit anderen Worten ist das dort anliegende Signal auf niedrigem Pegel, solange kein Fehler auftritt; es geht dann sprunghaft auf hohen Pegel, sobald ein Fehler aufgetreten ist. Danach sinkt es recht langsam ab, im wesentlichen durch Entladung des Kondensators 21 bzw. 25 über die Entladewiderstände 21' bzw. 25'. Die Dioden D1 und D2 verhindern dabei, daß sich die Kondensatoren undefiniert auch über die Ausgänge der EX-OR-Gatter 19 und 23 entladen können.

Das an den Komparatoren 22 und 26 gemeinsam anliegende Vergleichssignal (Kurve A in Fig. 2) stellt im Ergebnis während der Meßphase die Auf- und Abintegration des dynamischen Anteils (Kondensator 17') des invertierten Ausgangssignales $\bar{Q}$ des Flipflops 15 dar (das NAND-Gatter 17 invertiert das Signal Q). Die Entladezeitkonstante des Kondensators 28 wird durch den Widerstand 29 bestimmt, wobei diese in etwa gleich der Zeitkonstante für das Aufladen des Kondensators 28 ist. Damit erhält man bei kontinuierlichem Rechtecksignal (Ausgang von 17) ein im wesentlichen konstantes Signal am Punkt A, das als Vergleichssignal für die beiden Komparatoren 22 und 26 dient. Sobald nun ein Fehler auftritt, hat das Ausgangssignal des NAND- Gatters 17 eine "Impulslücke", so daß das Signal A um einen bestimmten Pegel absinkt, wodurch die beiden Komparatoren 22 und 26 noch empfindlicher geschaltet werden. Bei mehreren aufeinanderfolgenden "Impulslücken" sinkt das Signal A entsprechend weiter ab, so daß die Empfindlichkeit der beiden anderen Kanäle entsprechend erhöht wird.

Solange kein Fehler vorliegt ist der Ausgang des Komparators 22 auf "0", das Relais 30 also nicht erregt. Entsprechend umgekehrt ist der invertierte Ausgang des Komparators 26 bei fehlerfreiem Betrieb auf "1", das Relais 34 also erregt. Der Stromkreis zur (gelben) Diode 33 ist somit über die beiden Schalter 31 und 35 geschlossen. Die Diode 33 leuchtet. Durch den Inverter 37' erhält das EX-OR-Gatter 37 an seinen beiden Eingängen gleiche Signale, so daß sein Ausgang auf einer "0" ist. Das Relais 39 ist damit nicht erregt, der Schalter 40 in der geschlossenen Ruhestellung, so daß die (grüne) Leuchtdiode 42 leuchtet. Die (rote) Leuchtdiode 43 leuchtet dagegen nicht.

Bei einem "normalen" Störungsfall (Unterbrechung der Lichtstrecke 2 oder von anderen Lichtquellen auf den Empfänger auftreffendes Licht) schalten beide Komparatoren 22 und 26 um. Das Relais 30 zieht an, das Relais 34 fällt ab. Über die im Zusammenhang mit Fig. 5 beschriebene Rücksetzschaltung wird dann entweder Alarm ausgelöst oder die zu überwachende Maschine abgeschaltet. Durch das Umschalten der Relais 30 und 34 schalten auch die Schalter 90 und 91 um, so daß über die Leitung 77 (Schalter 74 geschlossen) das Relais 39 erregt wird, worauf die Schalter 40 und 41 umschalten. Die Leuchtdiode 42 erlischt, die (rote) Leuchtdiode 43 leuchtet.

Bei bestimmten Fehler wie z. B. Ausfall des ersten und/oder zweiten Kanales 19 bis 22 und/oder 23 bis 26 erhält das EX-OR-Gatter 37 an beiden Eingängen Signale mit gleichem Pegel. Es schaltet dann durch, womit über den Verstärker 38 das Relais 39 erregt wird. Die (grüne) Leuchtdiode 42 erlischt, die (rote) Leuchtdiode 43 leuchtet. Die Schalter 40 und 41 schalten um. Das Relais 39 kann also über zwei verschiedene Wege (90/91 oder 37/38) erregt werden.

Bei dem oben beschriebenen "normalen" Fehlerfall wurde davon ausgegangen, daß ein Lichtimpuls fehlt oder nicht in ausreichender Stärke am Empfänger ankommt. An den mit einem Stern bezeichneten Stellen der Fig. 2 wird nun der Fall erläutert, daß ein Lichtimpuls an einer Stelle auftritt, an der er eigentlich nicht auftreten dürfte. Es erscheint dann am Ausgang des Multiplexers 9 ein zusätzlicher, schraffiert dargestellter Impuls. Am Ausgang des Komparators 13 fehlt dann entsprechend der Impuls und ebenso phasenverschoben am Ausgang Q des Flipflops 15. Über die Exclusiv-ODER-Verknüpfung von Q (15) (dann logische "0") mit Q (16) (logische "1") erscheint dann am Ausgang des EX-OR-Gatters 19 wiederum ein Fehlerimpuls. Entsprechend gehen dann die Kurven B und C hoch und die Kurve A runter, wie bei dem ersten Fehler dargestellt. Der letzt diskutierte Fehlerfall ist bei den Kurven A, B und C der Fig. 2 nicht dargestellt.

Solange der Ausgang E des Zählers 12 eine logische "0" führt, befindet sich das System in einer Testphase. Entweder über den Ausgang E des Zählers 11 (das UND-Gatter ist dann fortgelassen) oder das UND-Gatter 8 werden der Multiplexer 8 oder der Sender 1 außer Betrieb gesetz und zwar so, daß der Eingang des Multiplexers mit keinem der Ausgänge verbunden ist oder daß kein Erregungsimpuls (Q von 10) zu den Leuchtdioden gelangt. Keine der Leuchtdioden 4 erhält damit ein Aktivierungssignal.

Im Gegensatz hierzu wird dagegen der Multiplexer 9 durch einen Zyklus geführt. Es wird also abgefragt, ob eines der photoempfindlichen Elemente 7 bis 7m ein (fälschliches) Signal empfängt. Solange dies nicht der Fall ist, steht am Ausgang des Multiplexers 9 ein Signal mit niedrigem Pegel an, der deutlich unter dem Schwellwert des Vergleichswertgebers 14 liegt, so daß der invertierende Komparator 13 im fehlerfreien Fall dann ständig eine logische "1" führt. Damit liegt auch am D-Eingang des Flipflops 15 ständig eine logische "1", so daß dieses an seinem Ausgang Q ständig den Pegel "1" führt, bei später ankommenden Taktsignalen Cl jedoch nicht mehr umschaltet. Der Ausgang Q des Flipflops 15 führt entsprechend ständig eine logische "0".

Durch die logische "0" am Ausgang E des Zählers 12 führt das NAND-Gatter 18 an seinem Ausgang ständig eine logische "1", unabhängig davon, was an seinem anderen Eingang passiert. Entsprechend schaltet auch das Flipflop 16 seinen Ausgang Q ständig auf eine logische 1 und seinen invertierten Ausgang Q ständig auf seine logische "0". Solange kein Fehler auftritt führen damit die beiden EX-OR-Gatter 19 und 23 an ihren Eingängen jeweils gleiche Signale, so daß ihre Ausgänge eine logische "0" führen. Die Punkte B und C sind damit auf niedrigem Pegel. Der Ausgang des NAND-Gatters 17 führt aufgrund der logischen "0" vom Ausgang E des Zählers 12 ständig eine logische "1". Der Kondensator 17' sperrt jedoch diesen Gleichspannungswert, so daß sich der Kondensator 28 über den Widerstand 29 entlädt und das Signal am Punkt A langsam auf Null geht. Tritt nun am Ausgang des Multiplexers 9 während der Testphase ein fehlerhaftes Signal auf, sei es durch von einer fremden Lichtquelle abgestrahltes Infrarotlicht im gleichen Wellenlängenbereich, sei es durch fehlerhafte Bauelemente der Schaltungsanordnung, so erscheint (in letzterem Fall natürlich nur bei bestimmten Fehlern) am Ausgang des Multiplexers 9 das in Fig. 2 bei der Testphase schraffiert dargestellte Signal. Entsprechend hat der Ausgang des Komparators 13 dann einen Einbruch seines Signalpegels auf eine logische 0, was dann phasenverschoben bei dem Flipflop 15 ebenfalls zu einem Einbruch (Ausgang Q) bzw. zu einem positiven Impuls (Q) führt. Das Flipflop 16 wird durch einen solchen Fehler dagegen nicht tangiert, so daß die EX-OR-Gatter 19 und 23 an ihren beiden Eingängen bei Auftreten des Fehlers jeweils unterschiedliche Signale haben, womit ihre Ausgänge einen kurzzeitigen Impuls mit einer logischen "1" führen. Wie oben beschrieben, gehen dann die Signale an den Punkten B und C sprunghaft nach oben, so daß die Komparatoren 22 und 26 wiederum ansprechen.

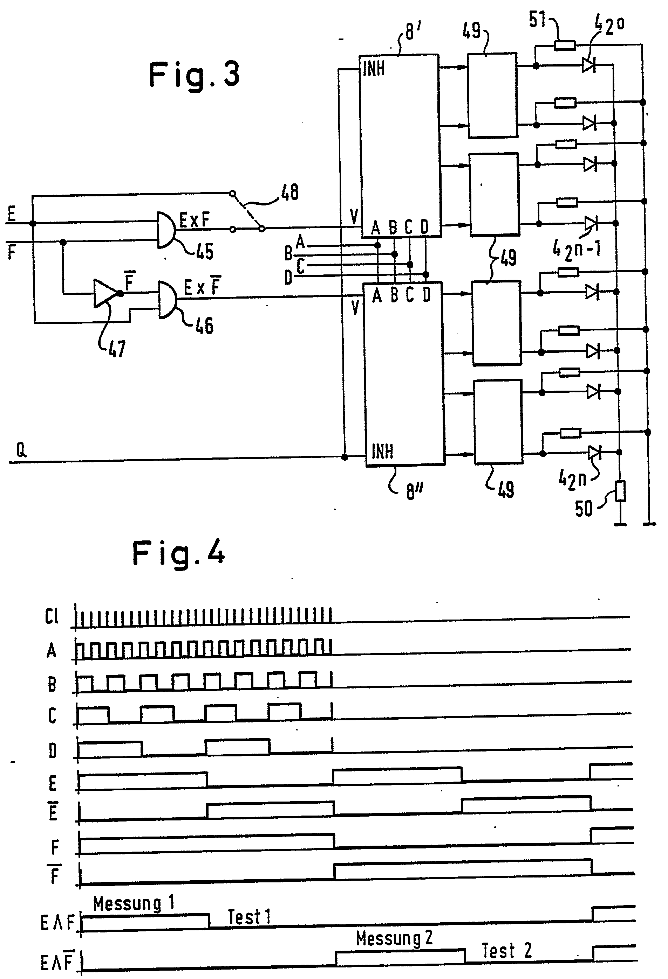

Fig. 3 zeigt detaillierter die Ansteuerung der sendeseitigen Multiplexer für den Fall mit 32 ($2^5$) Sende-Empfangskanälen. Bei dem Ausführungsbeispiel der Fig. 3 werden herkömmliche Multiplexer des Typs 4067 verwendet, die jeweils nur $2^4 = 16$ Kanäle ansteuern können. Dementsprechend sind zwei Multiplexer 8' und 8" vorgesehen, die an ihren Steuereingängen A, B, C und D die Ausgangssignale des Zählers 11 (Fig. 1) erhalten, die in Fig. 4 dargestellt sind. Im dargestellten Ausführungsbeispiel handelt es sich also um Zählimpulse im BCD-Code mit sechs Bitstellen A bis F. Die 4-Bit-Multiplexer 8' und 8" weisen nun jeweils noch einen Vorbereitungseingang V auf, der die Wirkung hat, daß der Multiplexer nur bei einer logischen "1" an diesem Eingang seine Funktion ausführt, während er bei einer logischen "0" an diesem Eingang das Signal Q von dem Oszillator 10 auf keinen der Ausgänge durchschaltet. Der Meß-Test-Zyklus läuft nun so ab, daß bei jedem der einzelnen Multiplexer 8' und 8" ein voller Zyklus mit Meßphase und Testphase abläuft, bevor der andere Multiplexer die entsprechenden Phasen ausführt. Hierzu werden die Ausgänge E und F des Zählers 11 verwendet, die über ein UND-Gatter 45 miteinander verknüpft dem Vorbereitungseingang V des ersten Multiplexers 8' zugeführt werden. Dem zweiten Multiplexer 8" wird dagegen über das UND-Gatter 46 eine Verknüpfung des Signales E und des durch den Inverter 47 invertierten Signales zugeführt, also letztlich die Verknüpfung E UND $\bar{F}$. Diese Signale sind ebenfalls in Fig. 4 dargestellt. Solange also E UND $\bar{F}$ eine logische 1 führen, führt der Multiplexer 8' seine zyklische Schaltung durch, so daß der Reihe nach die einzelnen Leuchtdioden $4_0$ bis $4_{2n-1}$ aktiviert werden. Das Signal E UND $\bar{F}$ ist während dieser Zeitdauer auf einer logischen "0", so daß der zweite Multiplexer 8' außer Betrieb gesetzt ist. In entsprechender Weise führt sodann der Multiplexer 8' die erste Testphase durch, worauf dann der zweite Multiplexer 8" seine Meßphase (Messung 2) und darauffolgend seine Testphase (Test 2) durchführt.

Mit einem 6-Bit-Zähler 16 lassen sich somit dann insgesamt 32 Leuchtdioden $4_{20}$ bis $4_{2n}$ betreiben. Werden nur 16 Dioden verwendet, so wird das Signal E direkt mit dem Vorbereitungseingang V des Multiplexers 8' verbunden, wie durch die gestrichelte Linie 48 angedeutet. Hierbei kann es sich auch um einen Umschalter handeln, so daß das System wahlweise mit 16 oder 32 Kanälen betrieben werden kann. In entsprechender Weise kann das System natürlich auch auf noch mehr Kanäle erweitert werden.

In Fig. 3 sind zwischen die Ausgänge der Multiplexer 8' und 8" und die Dioden jeweils noch Treibertransistoren 49 geschaltet. Die Kathoden der Leuchtdioden sind miteinander verbunden, wobei dieser Verbindungspunkt über einen Widerstand 50 mit Masse verbunden ist. An die Anoden der Dioden ist jeweils noch ein Ohm'scher Widerstand 51 angeschlossen, wobei die anderen Anschlüsse dieser Widerstände jeweils auf Masse liegen.

Fig. 5 zeigt detaillierter die Rücksetzschaltung 44. Die Relais 30, 34 und 39 mit ihren Schaltkontakten 90, 32, 91, 36 und 41 sind in Fig. 5 ebenfalls vorhanden und sind funktionsmäßig auch Teile der Rücksetzschaltung, obwohl sie in Fig. 1 getrennt von dieser dargestellt wurden. Die Rücksetzschaltung arbeitet insgesamt mit acht Relais, nämlich den Relais 30, 34 und 39 sowie den weiteren Relais 54, 55, 56, 57 und 58. Die Relais 56, 57 und 58 werden über die Schaltkontakte 32, 36 bzw. 41 der Relais 30, 34 bzw. 39 erregt, wobei die Schaltkontakte 32, 36 und 41 im Ruhezustand ihrer Relais keine Spannung führen dagegen im erregten Zustand ihrer Relais von der Leitung 59 positive Erregerspannung (hier: 24V) an das zugeordnete Relais 56, 57 bzw. 58 legen. Alle Schaltkontakte der Fig. 5 sind im Ruhezustand dargestellt. Die Relais 56 bis 58 betätigen jeweils ein Schalterpaar mit den Schaltern 60, 61 bzw. 62, 63 bzw. 64, 65. Die Schalter 60, 62 und 64 liegen in Reihenschaltung mit einer Rücksetztaste 66, wobei diese Reihenschaltung an die positive Versorgungsspannung (Leitung 59) angeschlossen ist. Sind die Relais 56 und 58 im Ruhezustand, so sind die Schalter 60 und 64 von der Rücksetztaste 66 abgetrennt. Im erregten Zustand sind die Schalter 60 und 64 dagegen mit der Rücksetztaste verbunden. Der Schalter 62 ist im Ruhezustand des Relais 57 mit dem Schalter 60 verbunden; im erregten Zustand des Relais 57 ist er dagegen von dem Schalter 60 abgetrennt. Der Ausgang der erwähnten Reihenschaltung 66, 60, 62 und 64 ist an eine Leitung 67 angeschlossen.

Die drei Schalter 61, 63 und 65 liegen ebenfalls in Reihenschaltung, wobei der Schalter 61 im Ruhezustand mit einer Leitung 68 verbunden ist. Der Schalter 63 ist im Ruhezustand geöffnet, während der Schalter 65 im Ruhezustand geschlossen ist und damit mit dem Schalter 63 verbunden ist. In Reihe zu diesen drei Schaltern 61, 63 und 65 liegt ein weiteres Relais 69, welches hier drei Schalter aufweist, die die aktiven Schalter für die Steuerung von Maschinenfunktionen sind. Wahlweise kann die Leitung 68 auf Masse oder positiver Versorgungsspannung liegen. Der andere Anschluß des Relais 69 liegt dann umgekehrt auf Versorgungsspannung bzw. Masse. Sind alle drei Schalter 61, 63 und 65 geschlossen, d. h. die Relais 61 und 65 im Ruhezustand und das Relais 34 im erregten Zustand, so wird das Relais 69 erregt, worauf die gewünschten Maschinenfunktionen (Betrieb) ausgelöst werden. Wechselt eines oder mehrere der Relais 56, 57 oder 58 diesen beschriebenen Zustand, so fällt das Relais 69 ab, wodurch beispielsweise die überwachte Maschine außer Betrieb gesetzt wird.

Im Störungsfalle liegt nur dann auf der Leitung 67 positives Potential, wenn gleichzeitig die Relais 56 und 58 erregt sind, das Relais 57 nicht erregt ist und die Rücksetztaste 66 gedrückt ist.

Spricht aufgrund eines Fehlers von Bauteilen der Schaltung das EX-OR-Gatter 37 an, so hat hierbei nur eines der Relais 30 oder 34 seinen Zustand gewechselt und entsprechend auch nur eines der Relais 56 oder 58. Der Reihenschaltung 60, 62, 64 ist damit durch einen geöffneten Schalter unterbrochen, so daß bei einem solchen Störungsfall ein Rücksetzen (Taste 66) nicht möglich ist.

Das Rücksetzen erfolgt durch die im folgenden beschriebenen Bauteile.

Zwischen die Leitung 67 und Masse bzw. 0 Volt ist das Relais 54 geschaltet. Parallel zu diesem Relais liegt eine Reihenschaltung aus einem Widerstand 70 und einem Kondensator 71. Der gemeinsame Verbindungspunkt dieser beiden Bauteile ist über eine Diode 72 mit dem Anschluß des Relais 54 verbunden, der an der Leitung 67 liegt. Das Relais 54 betätigt ebenfalls zwei Schalter, nämlich die Schalter 73 und 74. Im dargestellten Ruhezustand liegt der Schalter 73 so, daß er mit einem Widerstand 75 verbunden ist, dessen anderer Anschluß auf Masse bzw. 0 Volt liegt. Im erregten Zustand des Relais 54 ist der Schalter 73 an die Leitung 67 angeschlossen. Der Schalter 73 ist mit seinem dritten Anschluß über einen Kondensator 76 mit dem Relais 55 verbunden, dessen anderer Anschluß wiederum auf Masse bzw. 0 Volt liegt.

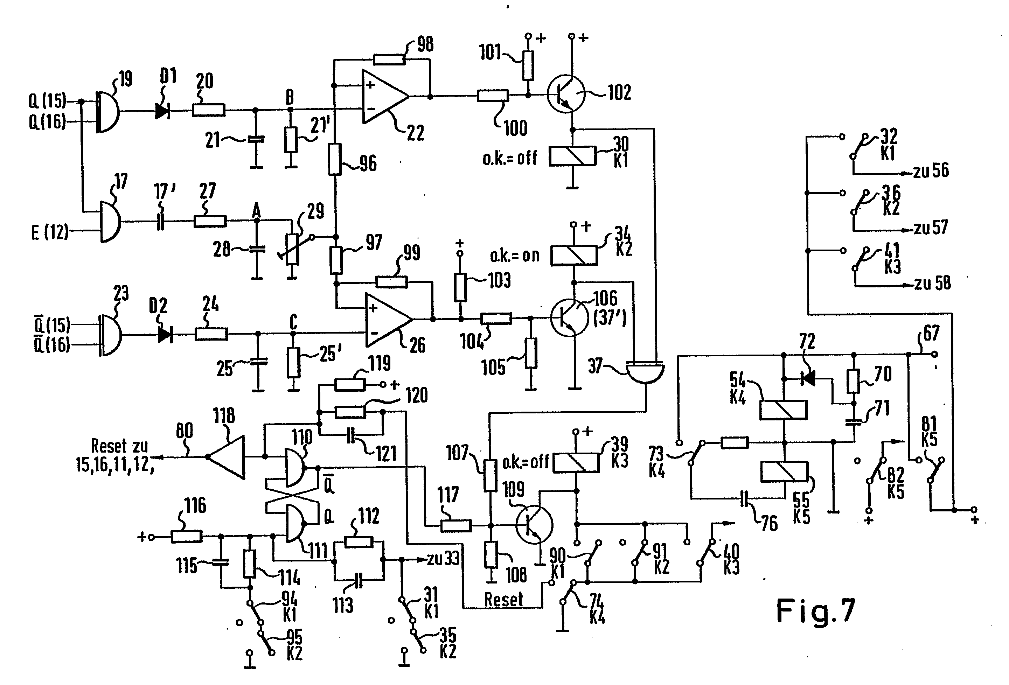

Die zweite Schalter 74 des Relais 54 schaltet hier Versorgungsspannung auf eine Leitung 77 (Ruhezustand) oder auf eine Parallelschaltung eines Widerstandes 78 und eines Kondensators 79, die ihrerseits an einem Anschluß 80 liegt (Relais erregt). Der Anschluß 80 führt dann das Reset-Signal, welches die Flipflops 15 und 16 sowie die Zähler 11 und 12 (Fig. 1) rücksetzt. So lange das Relais 54 nicht erregt ist, der Schalter 74 also in der gezeichneten Stellung ist, kann das Relais 39 über die Schalter 90 und/oder 91 erregt werden. Weitere Einzelheiten hierzu werden im Zusammenhang mit Fig. 7 erläutert.

Das Relais 55 hat ebenfalls zwei Schalter 81 und 82. Im Ruhezustand ist der Schalter 81 geöffnet. Im geschlossenen Zustand verbindet er die Leitung 67 mit der Leitung 59 und legt damit an die Leitung 67 Versorgungsspannung unabhängig von den Schaltern 60, 62, 64 und 66.

Der Schalter 82 ist im Ruhezustand geschlossen und verbindet dabei eine Speisespannung von hier 12 Volt mit einem Versorgungsanschluß 83 für die Speisung des Senders. Die erwähnte Speisespannung von + 12 Volt ist noch durch eine Zehnerdiode 84 gegen Spannungsspitzen geschützt sowie durch zwei Kondensatoren 85 und 86 geglättet.

Im folgenden wird die Arbeitsweise der Rücksetzschaltung der Fig. 5 erläutert. Solange kein Fehler vorliegt befindet sich die Schaltung in folgendem Zustand: Die Relais 30, 56; 39, 58 sowie 54, 55 und 69 sind abgefallen. Die zugeordneten Schalter sind in der dargestellten Ruhestellung. Die Relais 34 und 57 sind dagegen erregt, der Schalter 36 ist geschlossen und die Schalter 62 und 91 sind geöffnet. Durch den Schalter 62 ist damit der Stromkreis von der Rücksetztaste 66 zur Leitung 67 unterbrochen, ein Betätigen der Rücksetztaste hat keine Wirkung. Der Stromkreis zu dem Relais 69 ist durch die geschlossenen Schalter 63 sowie 61 und 65 geschlossen, so daß dieses Relais erregt ist und durch Schließen seiner zugeordneten Schalter die gewünschten Maschinenfunktionen aktiviert. Die Schalter 90 und 91 sind geöffnet, so daß das Relais 39 nicht über diesen Weg erregt ist.

Tritt nun ein Fehler auf, so wechselt mindestens eines der Relais 30, 34 und 39 und damit auch der Relais 56, 57 und 58 seinen Zustand. Zunächst sei eine "normale" Störung, z. B. eine Unterbrechung der Lichtschranke behandelt. Hierbei schalten die Relais 30, 34, 39, 56, 57 und 58 um, d. h. die Relais 30, 39, 56 und 58 ziehen an, während die Relais 34 und 57 abfallen. Damit wird der Versorgungsstromkreis für das Relais 69 über die Schalter 61, 63 und 65 unterbrochen, so daß dieses abfällt, wodurch die Maschine außer Betrieb gesetzt wird. Gleichzeitig wird durch die Schalter 60, 62 und 64 der Strompfad für die Betätigung der Rücksetztaste 66 durchgeschaltet. Wird diese gedrückt, so gelangt für die Dauer dieses Drückens positive Versorgungsspannung auf die Leitung 67 und damit an das Relais 54, welches anzieht. Weiterhin wird der Kondensator 71 aufgeladen und sorgt damit für eine Selbsthaltefunktion des Relais 54 für eine vorgegebene Zeitdauer. Durch das Anziehen des Relais 54 schaltet der Schalter 73 um und gibt über den Kondensator 76 einen kurzen Impuls an das Relais 55, welches damit kurzzeitig anzieht. Der Schalter 82 öffnet und trennt kurzzeitig die Energieversorgung für die Speisung des Senders ab, so daß dieser keine Lichtimpulse mehr aussenden kann. Über den Schalter 81 wird während dieser kurzen Zeitdauer die positive Versorgungsspannung noch einmal an das Relais 54 angelegt, so daß unabhängig von der Dauer des Drückens der Rücksetztaste 66 der Kondensator 71 für eine definierte Zeitdauer aufgeladen wird womit auch die Selbsthaltedauer des Relais 54 genau definiert ist. Durch das Anziehen des Relais 54 schaltet der Schalter 74 um, womit der Anschluß 80 auf Massepotential gelegt wird. Die Zähler 11 und 12 sowie die Flipflops 15 und 16 werden damit zurückgesetzt. Ist der zuvor erkannte Fehler, beispielsweise eine Unterbrechung der "Lichtschranke" beseitigt, so schaltet mit dem beschriebenen Rücksetzen auch die Rücksetzschaltung der Fig. 5 in den eingangs beschriebenen Zustand, d. h. die Relais 30, 39, 56, 58 fallen ab, während die Relais 34 und 57 anziehen. Ist dagegen weiterhin ein Fehler vorhanden, beispielsweise also die "Lichtschranke" noch unterbrochen, so schalten nach einem Rücksetzen die Relais 30, 34, 39 und 56, 57, 58 nicht wieder zurück, so daß auch ein kurzfristiges Inbetriebnehmen der überwachten Maschine während des Rücksetzvorganges nicht möglich ist.

Ein weiterer "Fehler" liegt dann vor, wenn die beiden Zähler 11 und 12 nicht synchron laufen, da dann ja die Erregung der Leuchtdioden 4 nicht mit dem Abfragen der photoempfindlichen Elemente 7 übereinstimmt. Dieser Fehlerfall wird von der Schaltungsanordnung in gleicher Weise behandelt, wie der oben beschriebene Fehler einer Unterbrechung der Lichtschranke.

Wie oben erwähnt, spricht dann das EX-OR-Gatter 37 an, wenn die beiden Kanäle (Ausgänge der Komparatoren 22 und 26) gleiche Signale führen, unter Berücksichtigung des Invertierers 37' also ungleiche Signale an den Eingängen des EX-OR-Gatters liegen. Ein solcher Fehler tritt dann auf, wenn einer der beiden Kanäle ausgefallen ist, beispielsweise durch Ausfall eines Bauelementes. Das Relais 39 wird dann über das EX-OR-Gatter 37 und den Verstärker 38 erregt, eventuell auch zusätzlich zu der Erregung über die Schalter 90, 91 und 74. In diesem Fehlerfalle schalten nicht die beiden Relais 30 und 34 um, womit auch nicht beide Relais 56 und 57 umschalten, so daß der Stromkreis von dem Taster 66 zur Leitung 67 unterbrochen bleibt. Ein Rücksetzen durch Betätigung des Tasters 66 ist damit nicht möglich. Somit kann auch durch fehlerhafte Bauteile nicht ein einwandfreier Betrieb vorgetäuscht werden. Vielmehr ist nur dann ein Rücksetzen möglich, wenn alle drei Relais 30, 34 und 39 und damit auch die Relais 56, 57 und 58 ihren Zustand wechseln.

Fig. 7 zeigt ein Schaltbild einer etwas abgewandelten Ausführungsform der Erfindung. Die Bauteile mit dem Bezugszeichen 1 bis 16 und 18 der Fig. 1, die auch bei der Ausführungsform der Fig. 7 benötigt werden, sind zur Vereinfachung der Darstellung fortgelassen. Will man die vollständige Schaltung erhalten, so muß man die Anschlüsse der Gatter 17, 19 und 23 mit den in Fig. 7 bezeichneten Anschlüssen der Bauteile 15, 16 und 12 der Fig. 1 verbinden. Bis zu den Komparatoren 22 und 26 entspricht die Auswerteschaltung der Fig. 7 (Bauteile mit dem Bezugzeichen 17 bis 26) dem Ausführungsbeispiel der Fig. 1, so daß auf die entsprechende Beschreibung Bezug genommen wird. Abweichend von Fig. 1 ist in Fig. 7 der Abgriff des Spannungsteilers 29 über je einen Widerstand 96 und 97 mit dem nicht-invertierenden Eingang der Komparatoren 22 und 26 verbunden. Weiterhin besitzen beide Komparatoren 22 und 26 je eine Rückkopplungswiderstand 98 bzw. 99 von ihrem Ausgang zum nicht-invertierenden Eingang. Der Ausgang des Komparators 22 ist über einen Widerstand 100 mit der Basis eines Transistors 102 verbunden, wobei die Basis über einen Widerstand 101 mit einer Vorspannung beaufschlagt ist. Da die Polarität der Eingänge des Komparators 22 gegenüber dem Ausführungsbeispiel der Fig. 1 vertauscht ist, ist sein Ausgangssignal gegenüber dem Ausführungsbeispiel der Fig. 1 gerade invertiert. Im Fehlerfalle (Signal B > Signal A) führt sein Ausgang also ein Signal mit niedrigem Pegel (z. B. Massepotential). In diesem Falle wird über den Spannungsteiler 101, 100 das Basispotential des Transistors 102 reduziert, worauf dieser durchschaltet und das Relais 30 erregt. Der Transistor 102 wirkt also als invertierender Verstärker. Durch die zweifache Invertierung gegenüber dem Ausführungsbeispiel der Fig. 1 erhält man im Ergebnis für das Relais 30 die gleichen Schaltzustände wie bei Fig. 1.

Um die Zuordnung der Relais zu ihren Schaltkontakten deutlicher hervorzuheben, sind an den jeweiligen Relais und ihren zugeordneten Kontakten noch die Bezeichnungen K1 bis K5 angebracht.

Beim zweiten Kanal sind gegenüber dem Ausführungsbeispiel der Fig. 1 am Komparator 26 ebenfalls die Eingangsanschlüsse vertauscht, so daß er in Fig. 7 als nicht-invertierender Verstärker ausgelegt ist. Der Ausgang des Komparators 26 ist mit einem Spannungsteiler verbunden, der aus den Widerständen 103 einerseits und 104 und 105 andererseits besteht. Der andere Anschluß des Widerstandes 103 liegt auf Versorgungsspannung. Der gemeinsame Verbindungspunkt der Widerstände 104 und 105 ist mit der Basis eines Transistors 106 verbunden, während der andere Anschluß des Widerstandes 105 auf Masse liegt. Im störungsfreien Betrieb (Signal C < Signal A) ist der Komparator 26 durchgeschaltet und aufgrund der Dimensionierung der Widerstände 103, 104 und 105 auch der Transistor 106, so daß das Relais 34 erregt ist. Im Störungsfalle ist dagegen das Ausgangspotential des Komparators 26 auf niedrigem Pegel, so daß auch der Transistor 106 sperrt und das Relais 34 nicht erregt ist. Hinsichtlich des dem EX-OR-Gatters 37 zugeführten Signales wirkt der Transistor 106 als invertierender Verstärker (entsprechend dem Inverter 37' der Fig. 1), da bei durchgeschaltetem Transistor 106 dem EX-OR-Gatter 37 ein Signal mit niedrigem Pegel zugeführt wird und umgekehrt.

Die Verschaltung der Relaiskontakte 32, 36 und 41 sowie der Relais 54 und 55 und der ihnen zugeordneten Bauteile (70 bis 81) entspricht dem Ausführungsbeispiel der Fig. 1 und braucht daher nicht noch einmal beschrieben zu werden. Abwandlungen gegenüber der Fig. 1 sind jedoch bei der Ansteuerung des Relais 39 vorhanden sowie den nachfolgend weiter beschriebenen Bauteilen.

Beim Ausführungsbeispiel der Fig. 7 liegen die Schalter 90 und 91 (parallel zueinander) in Reihenschaltung mit dem Schalter 74, wobei diese Reihenschaltung zwischen dem einen Anschluß des Relais 39 und Masse liegt. Auch in Fig. 7 sind alle Schalter im nicht-erregten Zustand ihrer Relais dargestellt. Im störungsfreien Betrieb sind also die beiden Schalter 90 und 91 geöffnet; der Schalter 74 ist in der dargestellten Ruhestellung. Schalten nun im Störungsfalle beide oder eines der Relais 30 und/oder 34 um, so schalten die zugeordneten Schalter 90 bzw. 91 um, so daß das Relais 39 über die Schaltung einer Masseverbindung erregt wird.

Während des Rücksetzvorganges wird - wie im Zusammenhang mit Fig. 5 beschrieben - das Relais 54 (K4) für eine vorgegebene Zeitdauer erregt, worauf auch der Schalter 74 umschaltet. Damit durch dieses Umschalten das Relais 39 nicht wieder abfällt ist eine Flipflopschaltung aus zwei kreuzweise miteinander verbundenen NAND-Gattern 110 und 111 vorgesehen. Solange der Schalter 74 in Ruhestellung ist, liegt ein Steuereingang des NAND-Gatters 110 über einen Widerstand 119 auf Versorgungsspannungspotential. Sobald der Schalter 74 durch Erregen des Relais 54 umgeschaltet hat, wird dagegen über einen Widerstand 120 und einen dazu parallel geschalteten Kondensator 121 der Steuereingang des NAND-Gatters 110 auf niedrigeres Potential gezogen, da die Widerstände 119 und 120 als Spannungsteiler zwischen Versorgungsspannung und Masse liegen. In diesem Fall führt dann der Ausgang des NAND-Gatters 110 ein Signal mit hohem Pegel. Dieses Potential wird über einen Widerstand 117 der Basis eines Transistors 109 zugeführt, welcher die Masseleitung des Relais 39 durchschaltet. Das Relais bleibt damit auch bei geöffnetem Schalter 74 im Fehlerfalle weiter erregt. Das Flipflop 110, 111 sorgt im Ergebnis für eine Selbsthaltefunktion des Relais 39. Das von dem Schalter 74 bei Erregung des Relais 54 zum Steuereingang des NAND-Gatters 110 durchgeschaltete Massepotential gelangt weiterhin an den Eingang eines Inverters 118, dessen Ausgang die Leitung 80 ist, die das Rücksetzsignal zu den Flipflops 15 und 16 und dem Zähler 11 und 12 leitet.

Wenn während des Rücksetzvorganges das Relais 54 nach der durch den Kondensator 71 bestimmten Selbsthaltezeit wieder abfällt und damit auch der Schalter 74 wieder in seine Ruhestellung zurückkippt, bleibt das Flipflop 110, 111 noch in dem bisherigen Schaltzustand, der im Ergebnis auch das Relais 39 noch erregt hält. Sobald nach dem Rücksetzen wieder ein störungsfreier Betrieb vorliegt, muß das Flipflop 110, 111 jedoch umschalten, damit das Relais 39 abfallen kann (Set-Funktion).

Hierzu ist der Steuereingang des anderen NAND-Gatters 111 über einen Spannungsteiler aus einem Widerstand 116 und einer Parallelschaltung eines Widerstandes 114 oder eines Kondensators 115 sowie eine Reihenschaltung aus Schaltkontakten 94 und 95 angesteuert. Der Schaltkontakt 94 wird durch das Relais 30 und der Schaltkontakt 95 durch das Relais 34 betätigt. Die beiden Schaltkontakte 94 und 95 liegen in Reihenschaltung zu dem Widerstand 114 und verbinden dessen Anschluß mit Masse. Der andere Anschluß des Widerstandes 116 liegt auf positiver Versorgungsspannung. Der Schalter 94 ist im Ruhezustand geschlossen, während der Schalter 95 im Ruhezustand geöffnet ist. Im Störungsfalle, bei dem die Schalter 94 und/oder 95 geöffnet sind, ist der Widerstand 114 von Masse abgetrennt, so daß an den Steuereingang des NAND- Gatters 111 Versorgungsspannung angelegt wird. Wenn der Ausgang des NAND-Gatters 110 auf hohem Pegel ist, ist damit bei diesem Schaltzustand an beiden Eingängen des NAND-Gatters 111 hohes Potential, so daß sein Ausgang auf niedrigem Potential liegt. Sobald nun nach Beseitigung des Fehlers die Schalter 94 und 95 umschalten, wird der Steuereingang des NAND-Gatters 116 auf niedriges Potential gezwungen, so daß sein Ausgang hohes Potential führt. Damit führen beide Eingänge des NAND-Gatters 110 hohes Potential, so daß das Flipflop 110, 111 umschaltet und der Ausgang des NAND- Gatters 110 niedriges Potential führt, worauf der Transistor 109 sperrt und das Relais 39 abfällt. Der normale Betrieb kann dann weiterlaufen.

Zusätzlich ist der Ausgang des EX-OR-Gatters 37 über einen Widerstand 107 mit der Basis des Transistors 109 verbunden. Sobald bei den oben beschriebenen Fehlern das EX-OR-Gatter 37 durchschaltet, gelangt dessen positives Ausgangspotential über den Widerstand 107 an die Basis des Transistors 109, so daß dieser wiederum durchschaltet und das Relais 39 erregt.

Eine weitere Selbsthaltefunktion für das Relais 39 ist noch durch den von ihm betätigten Schalter 40 vorgesehen. Auch dieser Schalter liegt in der Massezuleitung zu dem Relais 39. Hat das Relais 39 einmal angezogen, sei es über die Schalter 90 oder 91 oder über den Transistor 109, so schaltet auch der Schalter 40 um. Erst durch Umschalten des Schalters 74 bei einem Rücksetzvorgang wird diese Selbsthaltefunktion unwirksam.

Zur Ansteuerung der (gelben) Leuchtdiode 33 sind noch folgende Schaltungsteile vorgesehen: An den Steuereingang des NAND-Gatters 111 ist eine Parallelschaltung aus einem Widerstand 112 und einem Kondensator 113 angeschlossen, wobei der andere Anschluß dieser Parallelschaltung über eine Leitung mit der Leuchtdiode 33 verbunden ist und gleichzeitig über eine Reihenschaltung aus den Schaltern 31 und 35 mit Masse verbunden ist. Solange einer oder beide Schalter 31 und 35 geöffnet sind, wird über die Widerstände 116 und 112 positives Potential an dem einen Anschluß der Leuchtdiode gelegt. (Ihr anderer Anschluß liegt ebenfalls auf Versorgungsspannung). Damit leuchtet sie nicht. Erst wenn beide Schalter 31 und 35 geschlossen sind, wird die Masseverbindung hergestellt, worauf die Leuchtdiode wieder leuchtet. Da diese beiden Schalter den Relais 30 bzw. 34 zugeordnet sind, sind sie nur bei störungsfreiem Betrieb geschlossen. Bezüglich des Steuereinganges des NAND-Gatters 111 liegen bei geschlossenen Schaltern 94, 95 und 31, 35 die Widerstände 114 und 112 parallel zueinander, wobei diese Parallelschaltung zusammen mit dem Widerstand 116 einen Spannungsteiler bildet. Durch Dimensionierung dieser Widerstände kann die Triggerspannung für das NAND-Gatter 111 so festgelegt werden, daß das NAND-Gatter 111 nur dann umschaltet, wenn alle vier Schalter 94, 95, 31, 35 geschlossen sind.

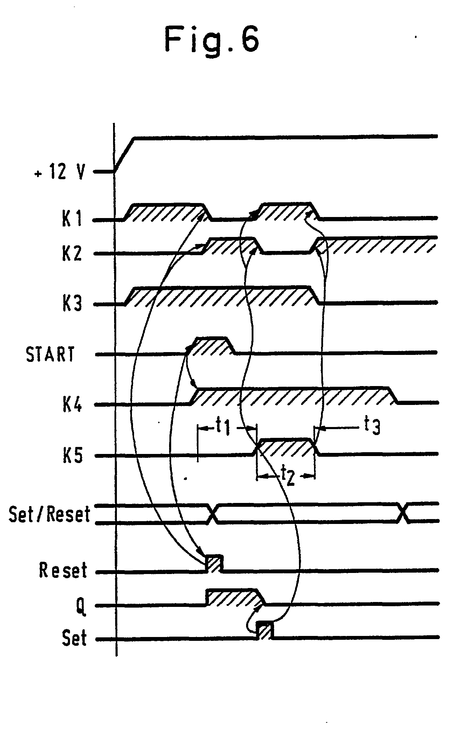

Aus Fig. 6 sind die zeitlichen Verläufe der Schaltzustände der einzelnen Relais zu erkennen, wobei in Anlehnung an Fig. 7 folgende Zuordnung gilt: Relais 30: K1, Relais 34: K2, Relais 39: K3, Relais 54: K4 und Relais 55: K5. Im Störungsfall sind K1 und K3 erregt, K2 ist abgefallen. Mit Drücken der Rücksetztaste 66 (Fig. 5) wird K4 erregt und das Rücksetzsignal "Reset" wird erzeugt (Schalter 74, Fig. 7). Zeitlich um $t_1$ verzögert, wird K5 erregt, wodurch die Energieversorgung für den Sender abgeschaltet wird. Sobald K5 wieder abfällt, wird der Sender wieder mit Energie versorgt. Die Zähler 11 und 12 und die Flipflops 15 und 16 sind bereits rückgesetzt, so daß dann der normale Betrieb beginnen kann, bei dem K1 und K3 abgefallen und K2 erregt ist.

## Patentansprüche

1. Lichtschranke mit mehreren Sendern (4) und diesen einzeln zugeordneten Empfängern (7), mit einer Steuerschaltung (10, 11, 12), die zyklisch die Sende-/Empfänger-Paare (4, 7) aktiviert, mit einer Auswerteschaltung, die in einem ersten Kanal (19, D1, 20, 21, 21', 22) überprüft, ob bei aktiviertem Sender (4) der zugeordnete Empfänger (7) anspricht und die in einem zweiten Kanal (23, D2, 24, 25, 25', 26) überprüft, ob trotz inaktivem Sender (4) der zugeordnete Empfänger (7) anspricht, und mit einem dritten Kanal, der auf dynamische Anteile von Ausgangssignalen der Empfänger (4) anspricht, dadurch gekennzeichnet, daß die Eingangssignale zu den drei Kanälen (19, D1, 20, 21, 21', 22; 23, D2, 24, 25, 25', 26; 17, 17', 27, 28, 29) digital und impulsförmig sind, daß die drei Kanäle jeweils auf- und abintegrierende Integrierer (20, 21; 27, 28; 24, 25) aufweisen, mit denen die impulsförmigen Eingangssignale in Analogsignale umgewandelt werden, und daß die Ausgangssignale der drei Integrierer (20, 21; 27, 28; 24, 25) zwei Komparatoren (22, 26) zugeführt werden, deren Ausgangssignale wieder digitale Signale darstellen, wobei das Ausgangssignal (A) des Integrierers (24, 25) des dritten Kanales (17, 17', 27, 28, 29) als Bezugswert für die beiden Komparatoren (22, 26) dient, wodurch das Ausgangssignal des Integrierers des dritten Kanales bei Auftreten eines Fehlers die Ansprechempfindlichkeit des ersten und zweiten Kanales (19, D1, 20, 21, 21', 22; 23, 24, 25, 25', 26) vergrößert.

2. Lichtschranke nach Anspruch 1, dadurch gekennzeichnet, daß die Auswerteschaltung zyklisch abwechselnd eine Meßphase durchläuft, wobei während der Meßphase die Sender (1) und Empfänger (3) aktiviert werden, während in der Testphase die Sender (1) inaktiv sind und die Empfänger (3) aktiv sind.

3. Lichtschranke nach Anspruch 1 oder 2, dadurch gekennzeichnet, daß einzelne Bauteile (z.B. 56 bis 69) einer von der Lichtschranke gesteuerten Anlage oder Maschine (z.B. Motorschütz, Relais) wirkungsmäßig in die Auswerteschaltung mit einbezogen sind.

4. Lichtschranke nach einem der Ansprüche 1 bis 3, dadurch gekennzeichnet, daß die Ausgangssignale des Empfängers (3) in einem Komparator (13) mit einem einstellbaren Schwellwert (14) verglichen werden, daß das Ausgangssignal dieses Komparators (13) dem D-Eingang eines Flipflops (15) zugeführt werden, dessen Ausgang (Q) den digitalisierten Istwert des Ausgangssignales des Empfängers (3) darstellt, daß ein zweites D-Flipflop (16) vorgesehen ist, dem die Erregerimpulse für die Sender (1) zugeführt werden, wobei das Ausgangssignal dieses Flipflops (16) einen Sollwert für das Vorhandensein von Lichtimpulsen darstellt, daß die Ausgangssignale (Q) in einem Exklusiv-Oder-Gatter (19) verglichen werden, dessen Ausgang das Eingangssignal des ersten Kanales darstellt, daß die invertierten Ausgänge (Q) der Flipflops (15 und 16) einem weiteren Exklusiv-Oder-Gatter (23) zugeführt werden, dessen Ausgang das Eingangssignal des zweiten Kanales bildet und daß das Ausgangssignal (Q) des ersten Flipflops (15) während der Meßphase das Eingangssignal des dritten Kanales bildet.

5. Lichtschranke nach einem der Ansprüche 1 bis 4, dadurch gekennzeichnet, daß das Ausgangssignal des ersten Kanales - mit Ausnahme von Ausfällen einzelner Bauelemente - stets invers zu dem Ausgangssignal des zweiten Kanales ist.

6. Lichtschranke nach Anspruch 5, dadurch gekennzeichnet, daß die Ausgangssignale des ersten und zweiten Kanales je ein Relais (30 bzw. 34) ansteuern, wobei bei störungsfreiem Betrieb das eine Relais erregt und das andere Relais entregt ist, wobei diesen Relais zugeordnete Schaltkontakte (32, 36) nur dann ein Inbetriebsetzen der von der Lichtschranke überwachten Anlage oder Maschine gestatten, wenn das eine Relais (34) erregt und das andere Relais (30) entregt ist.

7. Lichtschranke nach Anspruch 5 oder 6, dadurch gekennzeichnet, daß die Ausgangssignale des ersten und des zweiten Kanales in einem weiteren Exklusiv-Oder-Gatter (37) miteinander verglichen werden, wobei dieses Exklusiv-Oder-Gatter (37) dann anspricht, wenn - bedingt durch Ausfälle von Bauteilen - die Ausgangssignale des ersten und zweiten Kanales nicht invers zueinander sind und wobei die von der Lichtschranke überwachte Anlage oder Maschine bei Ansprechen des Exklusiv-Oder-Gatters (37) stillgesetzt wird.

8. Lichtschranke nach Anspruch 7, dadurch gekennzeichnet, daß ein drittes Relais (39) vorgesehen ist, das einerseits über das Exklusiv-Oder-Gatter (37) errregt wird und das andererseits durch das Umschalten von den Relais (30, 34) des ersten und zweiten Kanales zugeordneten Schaltkontakten erregt wird, wobei dieses Relais (39) einen Selbsthaltekontakt (40) hat und durch mindestens einen weiteren Schaltkontakt (41) ebenfalls die von der Lichtschranke überwachte Anlage oder Maschine stillsetzt, wobei aufgrund des Selbsthaltekontaktes (40) die Anlage oder Maschine nur durch Betätigen einer Rücksetztaste (66) wieder in Betrieb genommen werden kann.

9. Lichtschranke nach einem der Ansprüche 1 bis 8, dadurch gekennzeichnet, daß eine Rücksetzschaltung (44) vorgesehen ist, die nach Betätigen der Rücksetztaste (66) die Zähler (11, 12) und die Flipflops (15, 16) in einen definierten Ausgangszustand bringt, wobei eine Inbetriebnahme der von der Lichtschranke überwachten Anlage oder Maschine nur dann möglich ist, wenn nach dem Rücksetzen ein störungs- oder fehlerfreier Betrieb der Lichtschranke vorliegt.

**Claims**

1. A light barrier comprising a plurality of transmitters (4) and receivers (7) individually associated with the said transmitters, a control circuit (10, 11, 12) which cyclically activates the transmitter-receiver pairs (4, 7), an evaluation circuit, which in a first channel (19, D1, 20, 21, 21', 22) checks whether the associated receiver (7) responds when the transmitter (4) is activated and which in a second channel (23, D2, 24, 25, 25', 26) checks whether the associated receiver (7) responds even though the transmitter (4) is inactive, and comprising a third channel which responds to dynamic components of output signals of the receivers (7), characterised in that the input signals to the three channels (19, D1, 20, 21, 21', 22; 23, D2, 24, 25, 25', 26; 17, 17', 27, 28, 29) are digital and pulse-like, the three channels each comprise up and down integrating integrators (20, 21; 27, 28; 24, 25), by means of which the pulse-like input signals are converted into analog signals, and the output signals of the three integrators (20, 21; 27, 28; 24, 25) are supplied to two comparators (22, 26), whose output signals again represent digital signals, the output signal (A) of the integrator (24, 25) of the third channel (17, 17', 27, 28, 29) being used as a reference value for the two comparators (22, 26), the output signal of the integrator of the third channel thereby increasing the response sensitivity of the first and second channels (19, D1, 20, 21, 21', 22; 23, D2, 24, 25, 25', 26) in the event of an error.

2. A light barrier according to claim 1, characterised in that during alternate cycles the evaluation circuit passes through a measuring phase, the transmitter (1) and receiver (3) being activated during the measuring phase, whilst in the test phase the transmitter (1) is inactive and the receiver (3) is active.

3. A light barrier according to claim 1 or 2, characterised in that individual structural parts (e.g. 56 to 69) of a device or machine (e.g. motor contactor, relay) controlled by the light barrier are operationally included in the evaluation circuit.

4. A light barrier according to one of claims 1 to 3, characterised in that the output signals of the receiver (3) are compared in a comparator (13) with an adjustable threshold value (14), the output signal of the said comparator (13) is supplied to the D-input of a flip-flop (15), whose output (Q) represents the digitised actual value of the output signal of the receiver (1), in that a second D-flip-flop (16) is provided, to which the excitation pulses for the transmitters (1) are supplied, the output signal of the said flip-flop (16) representing a nominal value for the existance of light pulses, in that the output signals (Q) are compared in an Exclusive-OR-gate (19), whose output represents the input signal of the first channel, in that in the inverted outputs (Q) of the flip-flops (15 and 16) are supplied to a further Exclusive-OR-gate (23), whose output forms the input signal of the second channel and in that during the measuring phase the output signal (Q) of the first flip-flop (15) forms the input signal of the third channel.

5. A light barrier according to one of claims 1 to 4, characterised in that the output signal of the first channel is always – except when individual structural parts fail – inverse to the output signal of the second channel.

6. A light barrier according to claim 5, characterised in that the output signals of the first and second channels each trigger a relay (30 or 34), the first relay being activated and the second relay deactivated during disturbance-free operation, the switching contacts (32, 36) associated with the said relays only allowing the device or machine monitored by the light barrier to be started when the first relay (34) is excited and the second relay (30) is deactivated.

7. A light barrier according to claim 5 or 6, characterised in that the output signals of the first and second channels are compared with one another in a further Exclusive-OR-gate (37), the latter responding when – as a result of failing structural parts – the output signals of the first and second channels are not inverse to one another, the device or machine monitored by the light barrier being stopped when the Exclusive-OR-gate (37) responds.

8. A light barrier according to claim 7, characterised in that a third relay (39) is provided, which on the one hand is excited via the Exclusive-OR-gate (37) and on the other hand is excited by the switchover of switching contacts associated with the relays (30, 34) of the first and second channels, the said relay (39) comprising a holding contact (40) and also stopping the device or machine monitored by the light barrier by means of at least one further switching contact (41), it only being possible on account of the holding contact (40) to start the device or machine again by actuating a resetting button (66).

9. A light barrier according to one of claims 1 to 8, characterised in that a resetting circuit (44) is provided, which after actuation of the resetting button (66) returns the counters (11, 12) and the flip-flops (15, 16) to a defined starting position, it only being possible to start the device or machine monitored by the light barrier when, after resetting, there is a disturbance and error-free operation of the light barrier.

## Revendications

1. Barrière lumineuse comportant plusieurs émetteurs (4) et plusieurs récepteurs (7) qui se correspondent, et comportant un circuit de commande (10, 11, 12) qui active cycliquement les couples émetteur-récepteur (4, 7), comportant un circuit d'exploitation qui vérifie dans un premier canal (19, D1, 20, 21, 21', 22) si, un émetteur (4) étant activé, le récepteur (7) qui lui est affecté répond, et qui vérifie, dans un deuxième canal (23, D2, 24, 25, 25', 26) si, en dépit du fait que l'émetteur (4) soit inactif, le récepteur (7) qui lui est affecté répond, et comportant un troisième canal qui répond aux composantes dynamiques des signaux de sortie du récepteur (4), caractérisée en ce que les signaux d'entrée parvenant dans les trois canaux (19, D1, 20, 21, 21', 22; 23, D2, 24, 25, 25', 26; 17, 17', 27, 28, 29) sont numériques et se présentent sous forme d'impulsions, en ce que les trois canaux présentent chacun un dispositif intégrateur (20, 21; 27, 28; 24, 25) croissant et décroissant, au moyen desquels les signaux d'impulsions d'entrée sont transformés en signaux analogiques, et en ce que les signaux de sortie des trois intégrateurs (20, 21; 27, 28; 24, 25) sont envoyés jusqu'à deux comparateurs (22, 26) dont les signaux de sortie sont à nouveau des signaux digitaux, le signal de sortie (A) du dispositif intégrateur (24, 25) du troisième canal (17, 17', 27, 28, 29) servant de valeur de référence pour les deux comparateurs (22, 26), le signal de sortie du dispositif intégrateur du troisième canal augmentant de ce fait la sensibilité de réponse du premier et du second canal (19, D1, 20, 21, 21', 22; 23, D2, 24, 25, 25', 26), en cas d'apparition d'une défaillance ou d'un défaut.

2. Barrière lumineuse selon la revendication 1, caractérisée en ce que le circuit d'exploitation traverse cycliquement en alternance une phase de mesure, les émetteurs (1) et les récepteurs (3) étant activés au cours de la phase de mesure, tandis qu'au cours de la phase d'essai c'est le contraire.

3. Barrière lumineuse selon la revendication 1 ou la revendication 2, caractérisée en ce que les divers composants (par exemple 56 à 69) d'une installation ou d'une machine (par exemple la protection d'un moteur, un organe de relais) commandée par la barrière lumineuse sont incorporés fonctionnellement dans le circuit d'exploitation.

4. Barrière lumineuse selon une des revendications 1 à 3, caractérisée en ce que les signaux de sortie du récepteur (3) sont comparés à une valeur de seuil (14) réglable dans un comparateur (13), en ce que le signal de sortie de ce comparateur (13) est envoyé à l'entrée D d'une bascule (15) dont la sortie (Q) représente la valeur réelle, sous forme numérique, du signal de sortie du récepteur (3), en ce qu'une deuxième bascule D (16) est prévue, à laquelle sont envoyées les impulsions d'excitation destinées aux émetteurs (1), le signal de sortie de ce flip-flop (16) représentant une valeur de référence pour l'existence d'impulsions lumineuses, en ce que les signaux de sortie (Q) sont comparés dans un circuit logique OU-EXCLUSIF (19) dont la sortie est le signal d'entrée du premier canal, en ce que les sorties (Q) inversées des basculeurs (15 et 16) sont envoyées à un autre circuit logique OU-EXCLUSIF (23), dont la sortie donne le signal d'entrée (Q) de la première bascule (15) ainsi que celui du troisième canal, au cours de la phase de mesure.

5. Barrière lumineuse selon une des revendications 1 à 4, caractérisée en ce que le signal de sortie du premier canal - sauf éventuelle défaillance de composants individuels - est toujours inversé par rapport au signal d'entrée du deuxième canal.

6. Barrière lumineuse selon la revendication 5, caractérisée en ce que les signaux de sortie du premier et du second canal commandent chacun un relais (30 et 34), un des relais étant excité et l'autre relais ne l'étant pas, en cas de fonctionnement sans perturbation, des contacts de commutation (32, 36) affectés à ces relais n'autorisant alors la mise en marche de l'installation ou de la machine surveillée par la barrière lumineuse, que lorsque l'un des relais (34) est excité et que l'autre relais (30) ne l'est pas.

7. Barrière lumineuse, selon la revendication 5 ou 6, caractérisée en ce que les signaux de sortie du premier et du second canal sont comparés entre eux dans un autre circuit logique OU-EXCLUSIF (37), ce circuit (37) OU-EXCLUSIF réagissant lorsque - en raison de défaillance de pièces ou de composants - les signaux de sortie du premier et du second canal ne sont pas inversés l'un par rapport à l'autre et l'installation auquel cas la machine surveillée par la barrière lumineuse est mise à l'arrêt en réponse au signal du circuit logique OU-EXCLUSIF (37).

8. Barrière lumineuse, selon la revendication 7, caractérisée en ce qu'on prévoit un troisième relais (39) qui, d'une part, est excité par l'intermédiaire du circuit logique OU-EXCLUSIF (37) et qui est excité d'autre part la commutation, des contacts de commutation affectés aux relais (30, 34) du premier et du second canal, ce relais (39) comportant un contact (40) de maintien automatique et mettant également à l'arrêt l'installation ou la machine surveillée par la barrière lumineuse, au moyen d'au moins un autre contact de commutation (41), et l'installation ou la machine ne pouvant être remise en marche en raison du contact de maintien automatique (40), que par l'actionnement d'une touche (66) de remise à zéro.

9. Barrière lumineuse, selon une des revendications 1 à 8, caractérisée en ce qu'on prévoit un circuit de remise à zéro (44), lequel après actionnement de la touche (66) de remise à zéro met les compteurs (11, 12) et les bascules (15, 16) dans un état défini en sortie, une mise en fonctionnement de l'installation ou de la machine, surveillée par la barrière lumineuse, n'étant possible que lorsqu'après la remise à zéro, on a un fonctionnement exempt de défaillance ou de perturbation.

Fig.1

Fig.2

Fig.3

Fig.4

Fig.5

# Fig. 6

Fig.7

EP 0 230 517 B1